# EUROPEAN PATENT APPLICATION

(11) **EP 4 203 005 A2**
(43) Date of publication of application: **28.06.2023**
(21) Application number: 22209177.9
(22) Date of filing: 23.11.2022
(51) Int. Cl.: H01L 23/00, H01L 25/065, H01L 25/00

(54) **THROUGH-MOLD-INTERCONNECT STRUCTURE ON AN IC DIE DIRECTLY BONDED TO ANOTHER IC DIE**

(30) Priority: 24.12.2021 US 202117561832
(71) Applicant: INTEL Corporation, Santa Clara, CA 95054 (US)
(72) Inventor: MALLIK, Debendra, Chandler, 85226 (US); KARHADE, Omkar, Chandler, 85248 (US); DESHPANDE, Nitin, Chandler, 85226 (US)
(74) Representative: 2SPL Patentanwälte PartG mbB

(57) **Abstract**

An integrated circuit (IC) package comprises a first IC die comprising a first hardware interface at a first side of the first die, and one or more first conductive contacts at the first side. A second IC die coupled to the first die comprises a second hardware interface at a second side of the second die. Second conductive contacts of the first hardware interface are each in direct contact with a respective one of third conductive contacts of the second hardware interface. A third hardware interface comprises: one or more interconnect structures, each coupled to a respective one of the one or more first conductive contacts and each comprising a fourth conductive contact, and fifth conductive contacts at a third side of the second die, wherein the one or more interconnect structures are each to electrically couple the third hardware interface to the first die.

## Description

### BACKGROUND

Monolithic integrated circuit (IC) fabrication has restrictions that may limit a final product's performance. For this reason, alternatives to monolithic fabrication, such as various versions of IC die (dis)integration, are being investigated. One alternative to monolithic IC fabrication is assembling multiple chips into a multi-chip package (MCP). Another alternative is wafer-level stacking. With the wafer-level stacking technique, two or more wafers of monolithically fabricated ICs are bonded together. The wafers are then singulated into multiple stacked chip packages. Yet another alternative is die stacking. In die stacking, singulated IC die are vertically stacked after all the metallization layers in the separate IC dies have been completed.

An advantage of multi-chip packages is that they may enable IC dies from heterogeneous silicon processes to be combined, enable small dis-aggregated IC dies from identical silicon processes to be combined, or both. However, there are many challenges with integrating multiple IC dies into a single IC package.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
Fig. 1 illustrates a flow diagram of methods for assembling an IC package having bottom-side dies and interconnect structures encased in mold under a top-side die according to some embodiments.
Fig. 2A through 2H show cross-sectional side views of respective stages of processing to assemble an IC package according to some embodiments.
Fig. 3 illustrates a flow diagram of methods for assembling an IC package having bottom-side dies and via structures under a top-side die according to some embodiments.
Fig. 4A through 4F show cross-sectional side views of respective stages of processing to assemble an IC package according to some embodiments.
Fig. 5 illustrates a flow diagram of methods for assembling an IC package having bottom-side dies and interconnect structures encased in mold under a top-side die according to some embodiments.
Fig. 6A through 6E show cross-sectional side views of respective stages of processing to assemble an IC package according to some embodiments.
Fig. 7 illustrates a mobile computing platform and a data server machine employing an IC package, in accordance with some embodiments.
Fig. 8 is a functional block diagram of an electronic computing device, in accordance with some embodiments.

### DETAILED DESCRIPTION OF EXEMPLARY EMBODIMENTS

There are many challenges with integrating multiple IC chips (also referred to as tiles or chiplets) into a single IC package. For example, two or more middle IC dies may be stacked between larger top and bottom IC dies. In this arrangement, the top IC die may require electrical connections to the lower IC die, which may be a package substrate, e.g., for power and signal. One possible way to make the necessary electrical connections would be to use through-silicon vias (TSVs) inside the middle dies. Another possible way to make electrical connections would be to use through-dielectric vias (TDVs) in areas adjacent to the middle dies that have been filled with dielectric material.

A disadvantage of using TSVs in the middle first dies to connect the top IC die to the bottom IC die is that it requires the middle dies to be custom designed for the particular IC die package. It also complicates the design of and may increase the area of the middle dies. Use of TSVs for power may also introduce thermal cooling issues.

A disadvantage of using TDVs in areas adjacent to the middle dies to connect the top die to the third IC die relates to the dielectric material used to fill the space adjacent to and around the middle dies. The dielectric material is typically an oxide. Growing an oxide is an expensive and slow process. In addition, it is technically challenging to grow an oxide layer thicker than about 20-30 microns, with oxide layers beyond 40 microns being very difficult to form. The oxide layer needs to have the same thickness as the middle dies. Because the oxide layer is limited to about 20-30 micron, the middle dies would either need to be pre-thinned to the oxide layer thickness prior to being attached to the top die, or be thinned after being attached, if oxide is used as the space filler. Pre-thinned middle dies are fragile and difficult to handle. Middle dies that are thicker than the oxide layer are structurally more robust. However, the process of thinning the dies after attachment to the top IC die is difficult. Thinning after attachment is difficult because the middle dies contain copper TSVs that must be thinned and opened up, and it is difficult to thin the copper TSVs. Moreover, if the middle die is facing down it is impossible to thin the middle dies after attachment to the top die.

Embodiments are directed to a top-side IC die and at least one bottom-side IC die. The top-side IC die and bottom-side IC die are attached using a direct bonding (hybrid bonding) technique. A mold compound is used to fill the space around smaller bottom-side IC dies under the top-side IC die. The use of mold compound enables the bottom-side IC dies to be thicker than the bottom-side IC dies would need to be if the space around smaller bottom-side IC dies was filled with an oxide. In some embodiments, use of mold compound enables the bottom-side IC dies to be thicker than about 20-30 microns; in other embodiments, use of mold compound enables the bottom-side IC dies to be thicker than 40 microns. An advantage of various embodiments is that use of mold compound to fill space adjacent to and around tiles is that it is less expensive and can be applied faster than oxide. Another advantage of various embodiments is that bottom-side IC dies are structurally robust and relatively easy to handle due to their thickness.

Embodiments are also directed to at least one bottom-side IC die that has its TSVs revealed prior to being attached to a top-side IC die. After the at least one bottom-side IC die is attached to the top-side IC die, mold compound is used to fill the space around smaller bottom-side IC dies. If TSVs in the bottom-side IC die are not revealed prior to being attached to a top-side IC die, the process to reveal the TSVs after being encased mold is complex. An advantage of various embodiments is that the TSVs do not need to be revealed after being encased mold, and thus, a complex reveal process is avoided.

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Unless otherwise specified in the specific context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

The term "package" generally refers to a self-contained carrier of one or more dice, where the dice are attached to the package substrate, and may be encapsulated for protection, with integrated or wire-bonded interconnects between the dice and leads, pins or bumps located on the external portions of the package substrate. The package may contain a single die, or multiple dice, providing a specific function. The package is usually mounted on a printed circuit board for interconnection with other packaged integrated circuits and discrete components, forming a larger circuit.

The term "dielectric" generally refers to any number of non-electrically conductive materials that make up the structure of a package substrate. For purposes of this disclosure, dielectric material may be incorporated into an integrated circuit package as layers of laminate film or as a resin molded over integrated circuit dice mounted on the substrate.

The term "metallization" generally refers to metal layers formed over and through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and carries the same meaning. In addition, the term "conductive contact" may be used for "bond pad" and carries the same meaning.

The term "solder bump" generally refers to a solder layer formed on a bond pad. The solder layer typically has a round shape, hence the term "solder bump".

In this description and the claims, the terms "conductive contact" and "metal feature" have the same meaning. In this description and the claims, the term "interconnect structure" may refer to a "conductive pillar" or other interconnect structure.

The term "substrate" generally refers to a planar platform comprising dielectric and metallization structures. The substrate mechanically supports and electrically couples one or more IC dies on a single platform, with encapsulation of the one or more IC dies by a moldable dielectric material. The substrate generally comprises solder bumps as bonding interconnects on both sides. One side of the substrate, generally referred to as the "die side", comprises solder bumps for chip or die bonding. The opposite side of the substrate, generally referred to as the "land side", comprises solder bumps for bonding the package to a printed circuit board.

The vertical orientation is in the z-direction and it is understood that recitations of "top", "bottom", "above" and "below" refer to relative positions in the z-dimension with the usual meaning. However, it is understood that embodiments are not necessarily limited to the orientations or configurations illustrated in the figure.

Views labeled "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure.

IC die packages including a top-side IC die directly bonded to one or more bottom-side dies are described below. The IC package examples described herein may be manufactured, in part, with bonding techniques in which metal features embedded within an insulator of a top-side IC die are directly fused to metal features embedded within an insulator of a bottom-side die. Where both the metal features and the insulators are fused, the resultant composite structure comprises a hybrid bonded interface of both metallurgically interdiffused metals and chemically bonded insulators. Prior to bonding, each top-side IC die may be fabricated in a monolithic process separate from that of each bottom-side die. As such, each top-side IC die may utilize the same or different semiconductor device fabrication technologies as the bottom-side die bonded to the top-side die. Likewise, prior to assembly, the bottom-side die may be fabricated according a monolithic process separate from that of the top-side IC die.

Direct bonding, may also be referred to in this description and in the claims as hybrid bonding. As described above, direct bonding refers to a first IC die attached to a second IC die via bonds formed between both metallization features of the first IC die and the second IC die (e.g., via metal interdiffusion) and between dielectric materials of the first IC die and a second IC die.

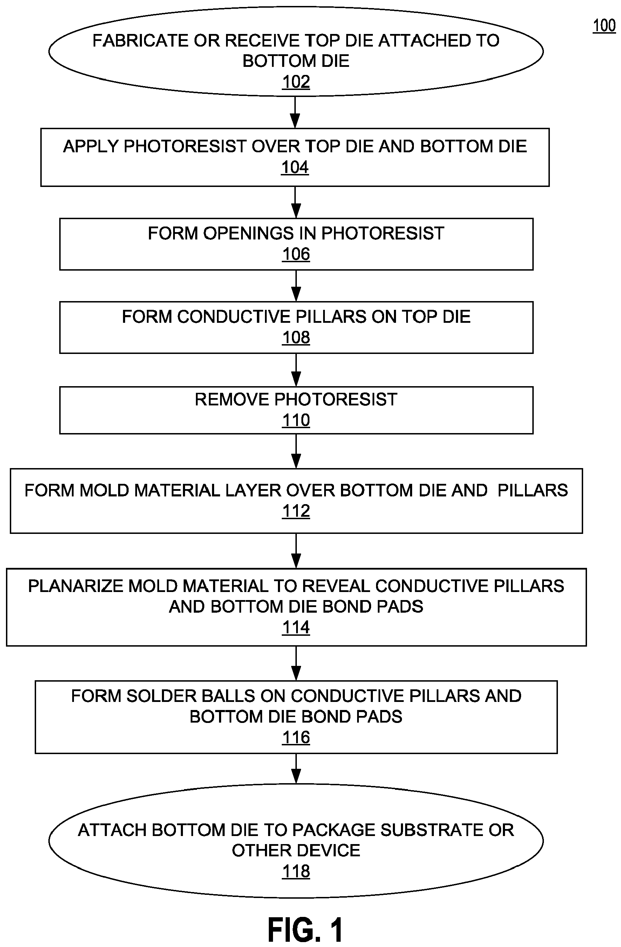

Fig. 1 illustrates a flow diagram of methods for assembling an IC package having bottom-side dies and interconnect structures encased in mold under a top-side die according to some embodiments. Methods 100 begin at 102, where a top-side IC die attached via hybrid bonding to at least one bottom side IC die is fabricated, or received as a preform that has been fabricated upstream of methods 100. A plurality of top-side IC dies may be fabricated monolithically from a substrate, such as a glass or silicon (e.g., monocrystalline) starting wafer. Similarly, a plurality of bottom side IC die may be fabricated monolithically from a substrate, such as a glass or silicon (e.g., monocrystalline) starting wafer.

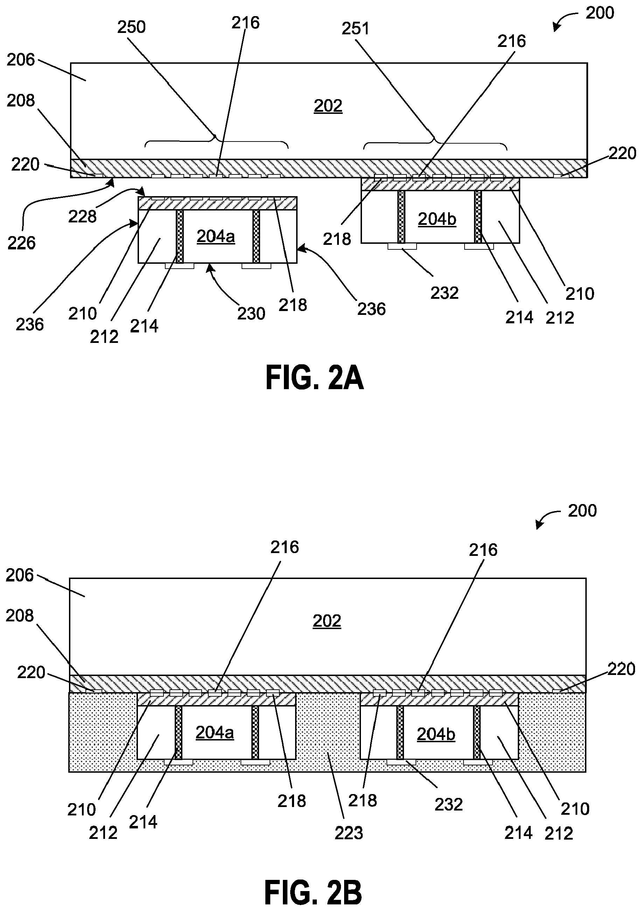

**Fig. 2A** is a cross-sectional illustration of one IC package 200 that may be received as a starting material at 102. Although only one IC package 200 is illustrated, IC package 200 may be one of IC package 200 of a monolithic wafer or reconstituted panel suitable for wafer-level or panel-level assembly.

IC package 200 comprises a top-side IC die 202 and at least one bottom-side IC die 204. In **Fig. 2A****,** bottom-side IC die 204a and bottom-side IC die 204b are shown. In various embodiments, multiple bottom-side IC die 204 may be attached to top-side integrated circuit die 202. While bottom-side IC die 204a is shown as not being attached to top-side die 202 in Fig. **2A****,** this only so that die surfaces 226, 228 can be easily seen. Contrary to **Fig. 2A****,** and as illustrated in **Figs. 2B** - **2H****,** bottom-side IC die 204a is attached to top-side die 202. In some embodiments, bottom-side IC dies 204a, 204b are thicker than 30. In some embodiments, bottom-side IC dies 204a, 204b are thicker than 40 microns.

Top-side IC die 202 comprises a device layer 206 and back-end-of-line (BEOL) metallization layer 208 that has been monolithically fabricated over device layer 206. Top-side integrated circuit IC die 202 can comprise one or more device layers 206. Similarly, top-side integrated circuit IC die 202 can comprise one or more metallization layers 208. Top-side IC die 202 includes a first surface 226, which can be a top surface of top-side IC die 202 as shown, or a bottom surface in some embodiments.

During front-end-of-line (FEOL) processing, active and/or passive devices are fabricated in device layer 206 at some device density associated with some device pitch. In some embodiments, the active devices are field effect transistors (FETs) with a device pitch of 80nm, or less. The FETs may be of any architecture (e.g., planar, non-planar, single-gate, multi-gate). In some embodiments, FET terminals have a feature pitch of 40-80nm. Additionally, or in the alternative, device layer 206 may include active devices other than FETs. For example, device layer 206 may include electronic memory structures, such as magnetic tunnel junctions (MTJs), or the like. In addition to active devices, or instead of active devices, device layer 206 may include passive devices (e.g., resistors, capacitors, inductors, etc.).

During BEOL processing, active and passive devices of device layer 206 are interconnected into circuitry with metal structures within one or more metallization layers 208. In some examples where device layer 206 includes both n-type and p-type FETs, the FETs are interconnected by metal structures into a CMOS circuitry. A metallization layer 208 may comprise any number of metal structures separated by inter-layer dielectric (ILD) material.

As illustrated in **Fig. 2A****,** top-side IC die 202 further includes a plurality of first metal features 216 and one or more second metal features 220 embedded within metallization layer 208 on the first surface 226. The plurality of first metal features 216 and at least one second metal features 220 are embedded within a dielectric material in metallization layer 208. Because the plurality of first metal features 216 interface with two or more bottom-side IC die 204, the plurality of first metal features 216 may be referred to, for ease of reference, as having groups or sets of metal features associated with a particular bottom-side IC die 204. Specifically, a first group or set of the plurality of first metal features 216 for interfacing with bottom-side IC die 204a may be referred to herein, and in the claims, as a first hardware interface 250. A second group or set of the plurality of first metal features 216 for interfacing with bottom-side IC die 204b may also be referred to herein, and in the claims, as a second hardware interface 251.

Each bottom-side IC die 204a, 204b comprises a device layer 212 and BEOL metallization layer 210 that has been monolithically fabricated over device layer 212. Bottom-side IC dies 204a, 204b can comprise one or more device layers 212. Similarly, bottom-side IC dies 204a, 204b can comprise one or more metallization layers 210.

Each bottom-side IC die 204a, 204b includes a first surface 228, which can be a top surface of bottom-side IC dies 204a, 204b as shown, or a bottom surface in some embodiments. Each of bottom-side IC die 204a and 204b includes a second surface 230 opposite the first surface 228. In addition, each of bottom-side IC die 204a and 204b includes a plurality of sidewalls or sidewall structures 236, e.g., four. Sidewalls 236 extend from first surface 228 to second surface 230 of bottom-side IC dies 204a, 204b.

Any of the active and passive devices described above as being fabricated in device layer 206 for top-side IC die 202 may be similarly fabricated in device layer 212 in each bottom-side IC die 204a, 204b. Like the metal structures within one or more metallization layers of 208 of top-side IC die 202, metal structures within one or more metallization layers 210 in each bottom-side IC die 204a, 204b interconnect active devices of device layer 212 into circuitry. In some embodiments, the circuitry in top-side IC die 202 and bottom-side IC die 204 may be the same. However, in other embodiments, the architectures and/or functions of circuitry in top-side IC die 202 may be different from the architectures and/or functions of circuitry in bottom-side IC dies 204a, 204b.

As illustrated in **Fig. 2A****,** bottom-side IC dies 204a, 204b further include a plurality of third metal features 218 on first surface 228. The plurality of third metal features 218 are embedded within a dielectric material in a metallization layer 210 on first surface 228. The plurality of third metal features 218 may be referred to herein as a second hardware interface. In addition, bottom-side IC dies 204a, 204b include at least one bond pad 232 on a second surface 230 opposite the first surface 228.

In embodiments, bottom-side IC dies 204a, 204b are attached to top-side IC die 202 via direct or hybrid bonding, in which bonds are formed between both metallization features of bottom-side IC dies 204a, 204b and top-side IC die 202 (e.g., via metal interdiffusion) and between dielectric materials of bottom-side IC dies 204a, 204b and top-side IC die 202.

With reference to bottom-side IC die 204b in **Fig. 2A-2H****,** one or more of the plurality of third metal features 218 of bottom-side IC die 204b are in direct contact with one or more of the plurality of first metal features 216 of top-side IC die 202. In embodiments, metal features 218 of the second hardware interface at surface 228 of second IC die 204b are in direct contact with metal features 216 of one of first hardware interface 250 of top-side IC die 202.

With reference to bottom-side IC die 204a, as illustrated in **Figs. 2B** - **2H****,** one or more of the plurality of third metal features 218 of die 204a are in direct contact with one or more the plurality of first metal features 216 of die 202. These one or more of the plurality of first metal features 216 of die 202 contacting third metal features 218 of die 204a may alternatively be referred to as a second group or a second set of the plurality of first metal features 216. In embodiments, metal features 218 of a fourth hardware interface at surface 228 of second IC die 204a are in direct contact with metal features 216 of one of first hardware interface 250 of top-side IC die 202.

Returning to **Fig. 1****,** conductive pillars 222 are formed in operations 104, 106, 108, and 110. In some embodiments, pillars 222 may be fabricated according to a semi-additive process (SAP), for example with Cu electroplated within a plating mask, and the plating mask removed following the plating. At 104, photoresist is applied over the top and bottom dies, as illustrated in **Fig. 2B****,** which is a cross-sectional illustration of IC package 200. As can be seen in **Fig. 2B****,** bottom-side IC die 204a and bottom-side IC die 204b are at least partially encased in photoresist 223. Any process for applying photoresist known in the art may be employed at 110. In addition, any suitable photoresist material may be used.

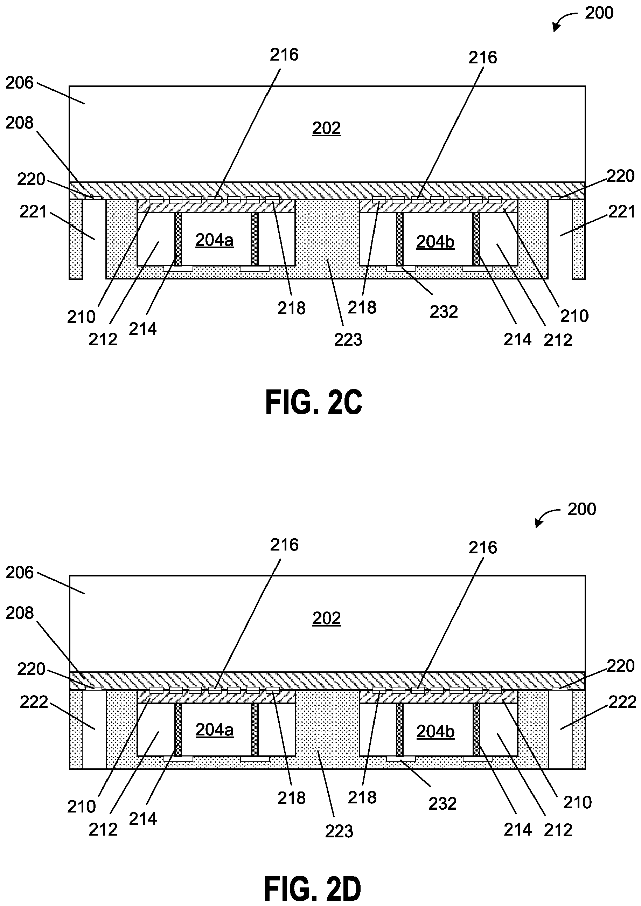

At 106 in **Fig. 1****,** at least one opening in the photoresist are formed. The opening may be formed by using a mask and an etch process. Any mask and an etch process known in the art may be employed to form openings 221. **Fig. 2C** is a cross-sectional illustration of IC package 200 showing openings 221 have been formed in photoresist 223 that encases bottom-side IC die 204a and bottom-side IC die 204b. Openings 221 are in areas adjacent to bottom-side IC die 204a and bottom-side IC die 204b. Any mask and an etch process for known in the art may be employed at 110.

At 108 in **Fig. 1****,** at least one conductive pillar 222 is formed on top-side die. Conductive pillars 222 may be copper and may be formed by a plating process. Any plating process known in the art may be employed to form conductive pillars 222. **Fig. 2D** is a cross-sectional illustration of IC package 200 showing conductive pillars 222 in bottom-side IC die 204a and bottom-side IC die 204b. The conductive pillars 222 are formed have been formed in openings 221 in photoresist 223.

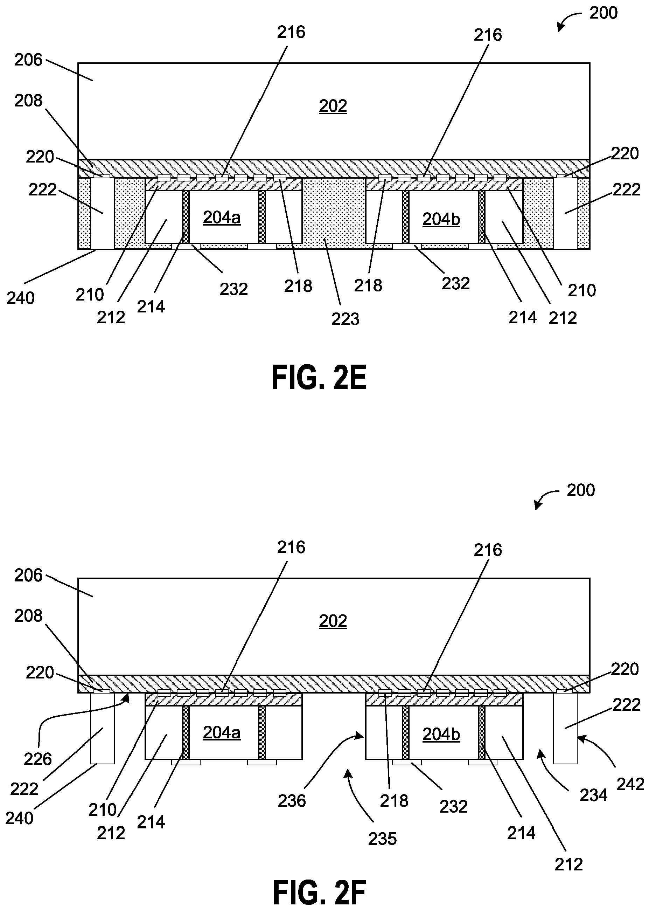

At 110 in **Fig. 1****,** conductive pillars 222 are thinned and planarized, and photoresist 223 is removed. **Fig. 2E** is a cross-sectional illustration of IC package 200 showing conductive pillars 222 extending to the same height as bond pads 232 of bottom-side IC dies 204a, 204b. Conductive pillars 222 have first end surface 240, which is exposed, i.e., not covered with photoresist material. First end surface 240 may be substantially on the same plane with an exposed surface of bond pad 232, the exposed surface being opposite a surface in contact with TSV 214. First end surfaces 240 may be referred to in this description and the claims as conductive contacts. Conductive pillars 222 may be thinned and planarized using any suitable methods known in the art. **Fig. 2F** is a cross-sectional illustration of IC package 200 showing the photoresist 223 having been removed. Photoresist 223 may be removed using any suitable methods known in the art. As can be seen in the figure, removal of photoresist 223 creates areas 234 and 235 that are adjacent to sides of bottom-side IC dies 204a, 204b and below surface 226. Areas 234 are also adjacent to sides of conductive pillars 222.

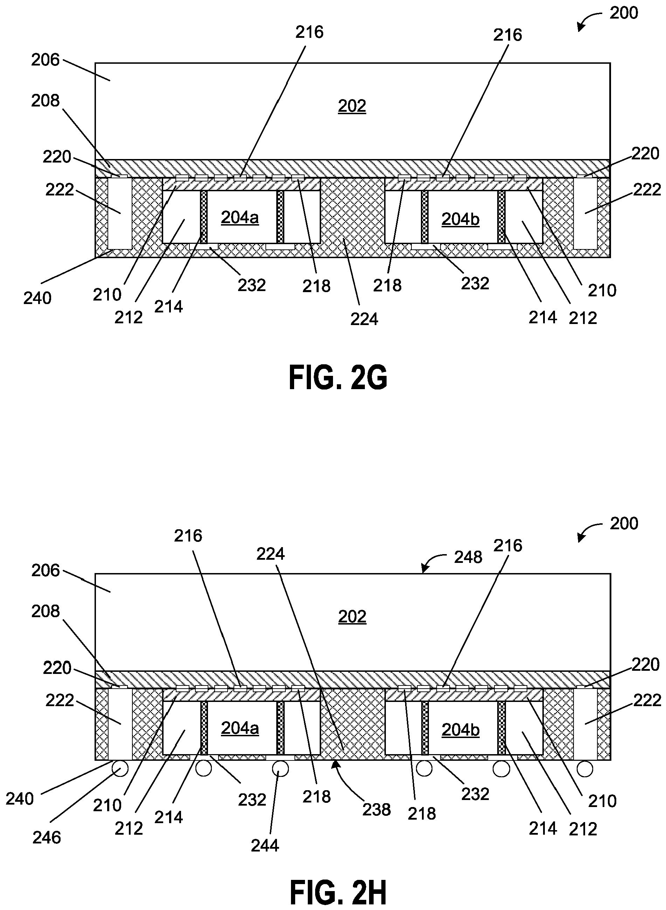

Returning to **Fig. 1****,** methods 100 continue at 112 where a mold material layer is formed. **Fig. 2G** is a cross-sectional illustration of IC package 200 showing conductive pillars 222 at least partially encased in a mold material layer 224 over surface 226. **Fig. 2G** also shows at least one bottom-side IC die, e.g., bottom-side IC dies 204a, 204b, at least partially encased in the mold material layer 224. Mold material layer 224 may also be referred to in this description and in the claims as "mold compound." The mold material layer or mold compound 224 may be any suitable an organic material or organic plastic material, such as an epoxy material. Mold material 224 may have a relatively low electrical conductivity, with mold material 224 advantageously being a dielectric. Mold material 224 may be any alternative material known to be suitable for IC chip packaging applications. In some exemplary embodiments, mold material 224 comprises a cured (e.g., thermoset) resin or polymer comprising epoxy and/or silicone. Mold material 224 may also comprise a variety of fillers. In some embodiments, mold material 224 has a relatively low bulk thermal conductivity (e.g., less than 5 W/mK), and may, for example, have a bulk thermal conductivity in the range of 1-4 W/mK. The processing and techniques for encasing integrated circuit device in a mold material layer are well known in the art and for purposes of clarity and conciseness are not discussed herein. Any suitable methods known in the art may be employed.

Returning to **Fig. 1****,** methods 100 continue at 114 where mold material 224 is planarized to expose bond pads 232 of bottom-side IC dies 204a, 204b and first end surfaces 240 of conductive pillars 222. For example, a grind and/or polish process may partially remove and/or planarize the mold material 224 to expose to reveal the conductive pillars and bottom-side die pads 232. **Fig. 2H** is a cross-sectional illustration of IC package 200 after material 224 has been planarized. As can be seen in the figure, first end surfaces 240 of conductive pillars 222 and bottom-side die pads 232 are exposed. It should be appreciated that mold material layer 224 defines a side 238 of IC package 200. As mentioned, top-side IC die 202 has a first surface 226 (see **Fig. 2A****).** Top-side IC die 202 also has a second surface 248 opposite first surface 226. Second surface 248 defines a side of IC package 200 which is opposite side 238 defined by the mold material layer 224.

In various embodiments, mold material layer 224 is a rigid body comprising a mold compound. The rigid body adjoins sidewall structure of 236 of bottom-side IC dies 204a, 204b. In addition, rigid body adjoins first surface 226 of top-side die 202. The conductive pillars 222 each adjoin and extend through the mold compound of the rigid body. Sidewalls 242 of interconnect structures 222 adjoin the mold compound of the rigid body. Referring to Figs. 2A, 2H, a distance between the side 226 of the IC die 202 and the first end surfaces 240 of conductive pillars 222 is greater than 90 microns.

Returning to **Fig. 1****,** methods 100 continue at 116 where solder balls are formed on the conductive pillars and bottom-side die pads. As can be seen in **Fig. 2H****,** solder balls 246 have been formed on first end surfaces 240 of conductive pillars 222 and solder balls 244 have been formed on bottom-side die bond pads 232. Solder balls 244, 246 may be solder spheres having a spherical form indicative of a free-surface solder reflow. Solder balls 244, 246 may be of any solder composition known to be suitable for electrically connecting IC dies. In some embodiments, solder balls 244, 246 comprise a metal. In some exemplary embodiments, solder balls 244, 246 are of a Sn--Ag--Cu (SAC) alloy.

Returning to **Fig. 1****,** methods 100 may continue at 118 where the bottom-side die is attached to a package substrate or other device. Bottom-side IC dies 204a, 204b may be connected to a package substrate or other device via the solder balls 244 on die pads 232. Top-side IC die 202 may be connected to a package substrate or other device via the solder balls 246 on conductive pillars 222. Non-solder embodiments are also possible where bottom-side die bond pads 232 and conductive pillars 222 are directly bonded (e.g., Cu-Cu bumps) to a package substrate or other device.

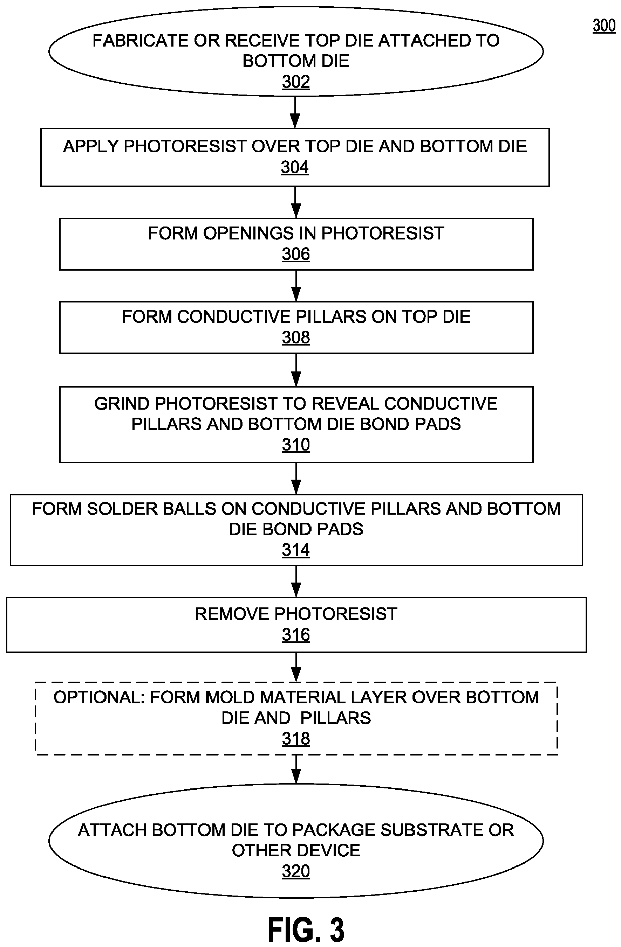

**Fig. 3** illustrates a flow diagram of methods for assembling an IC package having bottom-side dies and interconnect structures encased in mold under a top-side die according to some embodiments. Methods 300 begin at 302, where a top-side IC die attached via hybrid bonding to at least one bottom side IC die is fabricated, or received as a preform that has been fabricated upstream of methods 300. A plurality of top-side IC dies may be fabricated monolithically from a substrate, such as a glass or silicon (e.g., monocrystalline) starting wafer. Similarly, a plurality of bottom side IC die may be fabricated monolithically from a substrate, such as a glass or silicon (e.g., monocrystalline) starting wafer.

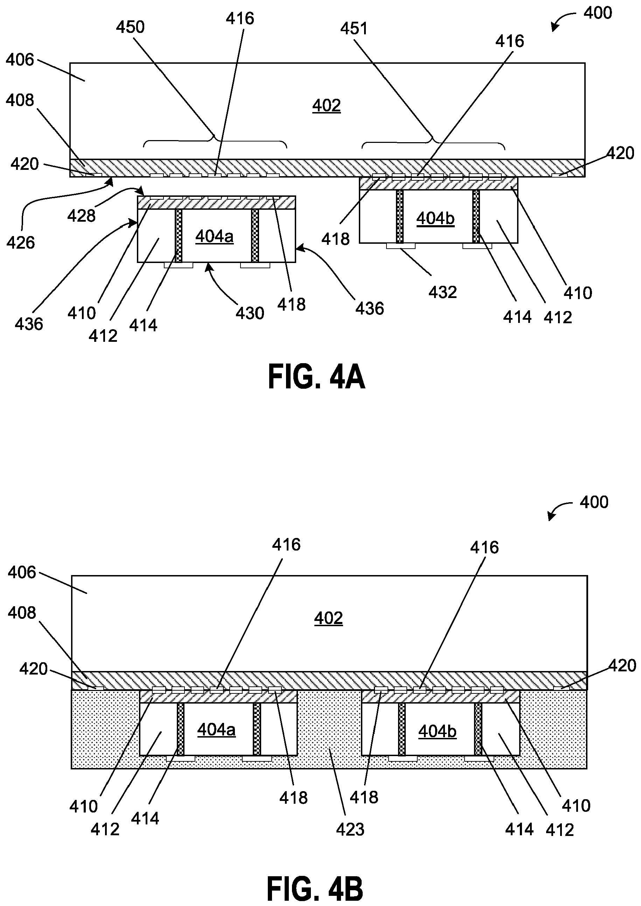

**Fig. 4A** is a cross-sectional illustration of one IC package 400 that may be received as a starting material at 302. Although only one IC package 400 is illustrated, IC package 400 may be one of IC package 400 of a monolithic wafer or reconstituted panel suitable for wafer-level or panel-level assembly.

IC package 400 comprises a top-side IC die 402 and at least one bottom-side IC die 404. In **Fig. 4A****,** bottom-side IC die 404a and bottom-side IC die 404b are shown. In various embodiments, multiple bottom-side IC die 404 may be attached to top-side integrated circuit die 402. While bottom-side IC die 404a is shown as not being attached to top-side die 402 in **Fig. 4A****,** this only so that die surfaces 426, 428 can be easily seen. Contrary to **Fig. 4A****,** and as illustrated in **Figs. 4B** - **4F****,** bottom-side IC die 404a is attached to top-side die 402. In some embodiments, bottom-side IC dies 404a, 404b are thicker than 30 microns. In some embodiments, bottom-side IC dies 404a, 404b are thicker than 40 microns.

Top-side IC die 402 comprises a device layer 406 and back-end-of-line (BEOL) metallization layer 408 that has been monolithically fabricated over device layer 406. Top-side integrated circuit IC die 402 can comprise one or more device layers 406. Similarly, top-side integrated circuit IC die 402 can comprise one or more metallization layers 408. Top-side IC die 402 includes a first surface 426, which can be a top surface of top-side IC die 402 as shown, or a bottom surface in some embodiments.

During front-end-of-line (FEOL) processing, active and/or passive devices are fabricated in device layer 406 at some device density associated with some device pitch. In some embodiments, the active devices are field effect transistors (FETs) with a device pitch of 80nm, or less. The FETs may be of any architecture (e.g., planar, non-planar, single-gate, multi-gate). In some embodiments, FET terminals have a feature pitch of 40-80nm. Additionally, or in the alternative, device layer 406 may include active devices other than FETs. For example, device layer 406 may include electronic memory structures, such as magnetic tunnel junctions (MTJs), or the like. In addition to active devices, or instead of active devices, device layer 406 may include passive devices (e.g., resistors, capacitors, inductors, etc.).

During BEOL processing, active and passive devices of device layer 406 are interconnected into circuitry with metal structures within one or more metallization layers 408. In some examples where device layer 406 includes both n-type and p-type FETs, the FETs are interconnected by metal structures into a CMOS circuitry. A metallization layer 408 may comprise any number of metal structures separated by inter-layer dielectric (ILD) material.

As illustrated in **Fig. 4A****,** top-side IC die 402 further includes a plurality of first metal features 416 and one or more a second metal features 420 embedded within metallization layer 408 on the first surface 426. The plurality of first metal features 416 and at least one interconnect structure 422 are embedded within a dielectric material in metallization layer 408. Because the plurality of first metal features 416 interface with two or more bottom-side IC die 404, the plurality of first metal features 416 may be referred to, for ease of reference, as having groups or sets of metal features associated with a particular bottom-side IC die 404. Specifically, a first group or set of the plurality of first metal features 416 for interfacing with bottom-side IC die 404a may be referred to herein, and in the claims, as a first hardware interface 450. A second group or set of the plurality of first metal features 416 for interfacing with bottom-side IC die 404b may also be referred to herein, and in the claims, as first hardware interface 451.

Each bottom-side IC die 404a, 404b comprises a device layer 412 and BEOL metallization layer 410 that has been monolithically fabricated over device layer 412. Bottom-side IC dies 404a, 404b can comprise one or more device layers 412. Similarly, bottom-side IC dies 404a, 404b can comprise one or more metallization layers 410.

Each bottom-side IC die 404a, 404b includes a first surface 428, which can be a top surface of bottom-side IC dies 404a, 404b as shown, or a bottom surface in some embodiments. Each of bottom-side IC die 404a and 404b includes a second surface 430 opposite the first surface 428. In addition, each of bottom-side IC die 404a and 404b includes a plurality of sidewalls or sidewall structures 436, e.g., four. Sidewalls 436 extend from first surface 428 to second surface 430 of bottom-side IC dies 404a, 404b.

Any of the active and passive devices described above as being fabricated in device layer 406 for top-side IC die 402 may be similarly fabricated in device layer 412 in each bottom-side IC die 404a, 404b. Like the metal structures within one or more metallization layers of 408 of top-side IC die 402, metal structures within one or more metallization layers 410 in each bottom-side IC die 404a, 404b interconnect active devices of device layer 412 into circuitry. In some embodiments, the circuitry in top-side IC die 402 and bottom-side IC die 404 may be the same. However, in other embodiments, the architectures and/or functions of circuitry in top-side IC die 402 may be different from the architectures and/or functions of circuitry in bottom-side IC dies 404a, 404b.

As illustrated in **Fig. 4A****,** bottom-side IC dies 404a, 404b further include a plurality of third metal features 418 on first surface 428. The plurality of third metal features 418 embedded within metallization layer 410 on first surface 428. The plurality of third metal features 418 are embedded within a dielectric material in metallization layer 410. The plurality of third metal features 418 may be referred to herein as a second hardware interface. In addition, bottom-side IC dies 404a, 404b include at least one bond pad 432 on a second surface 430 opposite the first surface 428.

In embodiments, bottom-side IC dies 404a, 404b are attached to top-side IC die 402 via direct or hybrid bonding, in which bonds are formed between both metallization features of bottom-side IC dies 404a, 404b and top-side IC die 402 (e.g., via metal interdiffusion) and between dielectric materials of bottom-side IC dies 404a, 404b and top-side IC die 402. In embodiments, metal features 418 (conductive contacts) of a second hardware interface at surface 428 of second IC die 404b are in direct contact with metal features 416 (conductive contacts) of one of first hardware interfaces 450 of top-side IC die 402.

With reference to bottom-side IC die 404a, as illustrated in in **Figs. 4B** - **4F****,** one or more of the plurality of third metal features 418 of die 404a are in direct contact with one or more the plurality of first metal features 416 of die 402. These one or more of the plurality of first metal features 416 of die 402 contacting third metal features 418 of die 404a may alternatively be referred to as a second group or a second set of the plurality of first metal features 416. In embodiments, metal features 418 (conductive contacts) of a second hardware interface at surface 428 of second IC die 204a are in direct contact with metal features 216 (conductive contacts) of one of first hardware interfaces 450 of top-side IC die 402.

Returning to **Fig. 3****,** conductive pillars 422 are formed in operations 304, 306, 308, and 310. In some embodiments, pillars 422 may be fabricated according to a semi-additive process (SAP), for example with Cu electroplated within a plating mask, and the plating mask removed following the plating. At 304, photoresist is applied over the top and bottom dies, as illustrated in **Fig. 4B****,** which is a cross-sectional illustration of IC package 400. As can be seen in **Fig. 4B****,** bottom-side IC die 404a and bottom-side IC die 404b are at least partially encased in photoresist 423. Any process for applying photoresist known in the art may be employed at 310. In addition, any suitable photoresist material may be used.

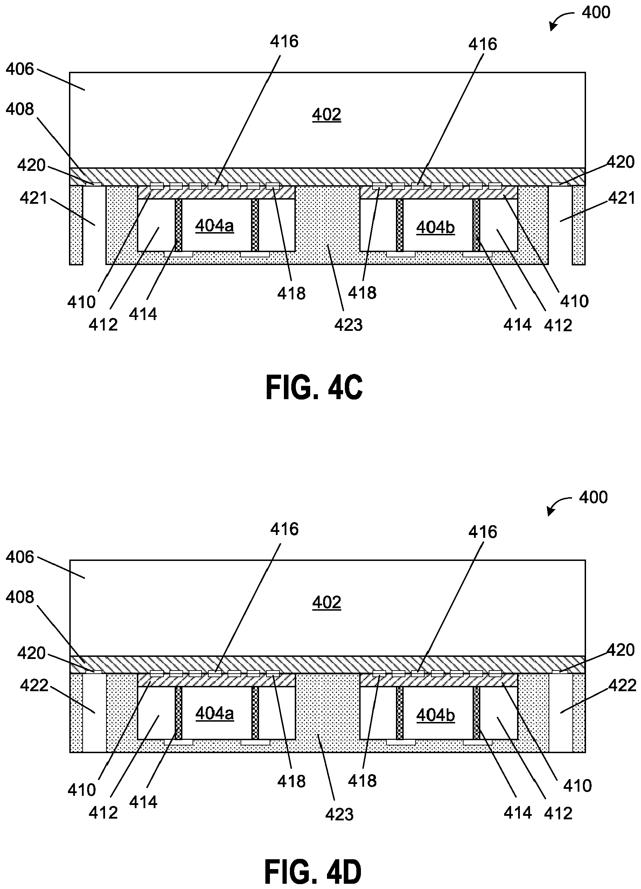

At 306 in **Fig. 3****,** at least one opening in the photoresist is formed. The opening may be formed by using a mask and an etch process. Any mask and an etch process known in the art may be employed to form openings 421. **Fig. 4C** is a cross-sectional illustration of IC package 400 showing openings 421 have been formed in photoresist 423 that encases bottom-side IC die 404a and bottom-side IC die 404b. Openings 421 are in areas adjacent to bottom-side IC die 404a and bottom-side IC die 404b. Any mask and an etch process for known in the art may be employed at 310.

At 308 in **Fig. 3****,** at least one conductive pillar 422 is formed on top-side die. Conductive pillars 422 may be copper and may be formed by a plating process. Any plating process known in the art may be employed to form conductive pillars 422. **Fig. 4D** is a cross-sectional illustration of IC package 400 showing conductive pillars 422 in bottom-side IC die 404a and bottom-side IC die 404b. The conductive pillars 422 are formed in openings 421 in photoresist 423.

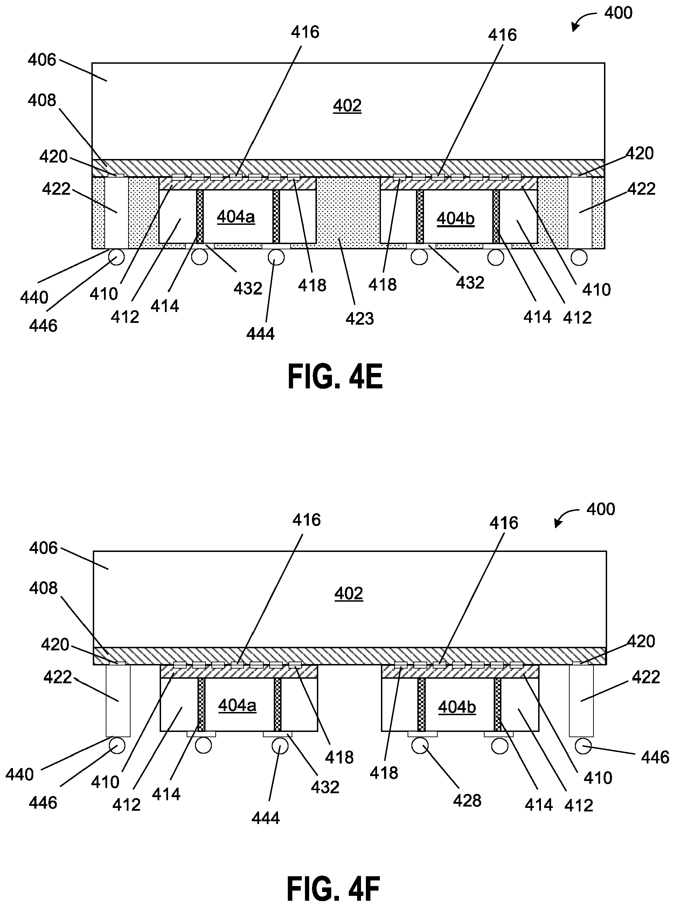

At 310 in **Fig. 3****,** conductive pillars 422 are thinned and planarized, and photoresist 423 is removed. **Fig. 4E** is a cross-sectional illustration of IC package 400 showing conductive pillars 422 extending to the same height as bond pads 432 of bottom-side IC dies 404a, 404b. Conductive pillars 422 have first end surfaces 440, which are exposed, i.e., not covered with photoresist material. First end surface 440 may be substantially on the same plane with an exposed surface of bond pad 432, the exposed surface being opposite a surface in contact with TSV 414. Conductive pillars 422 may be thinned and planarized using any suitable methods known in the art.

Returning to **Fig. 3****,** methods 300 continue at 314 where solder balls are formed on the conductive pillars and bottom-side die pads. As can be seen in **Fig. 4E****,** solder balls 446 have been formed on first end surfaces 440 of conductive pillars 422 and solder balls 444 have been formed on bottom-side die bond pads 432. Solder balls 444, 446 may be solder spheres having a spherical form indicative of a free-surface solder reflow. Solder balls 444, 446 may be of any solder composition known to be suitable for electrically connecting IC dies. In some embodiments, solder balls 444, 446 comprise a metal. In some exemplary embodiments, solder balls 444, 446 are of a Sn--Ag--Cu (SAC) alloy.

Returning to **Fig. 3****,** methods 300 continue at 316 where photoresist 423 is removed. **Fig. 4F** is a cross-sectional illustration of IC package 400 showing the photoresist 423 having been removed. Photoresist 423 may be removed using any suitable methods known in the art. As can be seen in the figure, removal of photoresist 423 creates areas 434 and 435 that are adjacent to sides of bottom-side IC dies 404a, 404b and below surface 426. Areas 434 are also adjacent to sides of conductive pillars 422. Referring to Figs. 4A, 4F, a distance between the side 426 of the IC die 402 and the first end surfaces 440 of conductive pillars 422 is greater than 90 microns in some embodiments.

Returning to **Fig. 3****,** methods 300 may continue at 318 where a mold material layer may be formed and then a ground and/or polished to partially remove and/or planarize the mold material to expose to reveal the conductive pillars and bottom-side die pads, as described above with respect to methods 100. However, operations 318 are optional and methods 300 may continue to 320, where bottom-side dies 404a, 404b attached to a package substrate or other device. Bottom-side IC dies 404a, 404b may be connected to a package substrate or other device via the solder balls 444 on die pads 432. Top-side IC die 402 may be connected to a package substrate or other device via the solder balls 446 on conductive pillars 422 so that top-side IG die 402 is electrically coupled with the package substrate or other device. Non-solder embodiments are also possible where bottom-side die bond pads 432 and conductive pillars 422 are directly bonded (e.g., Cu-Cu bumps) to a package substrate or other device.

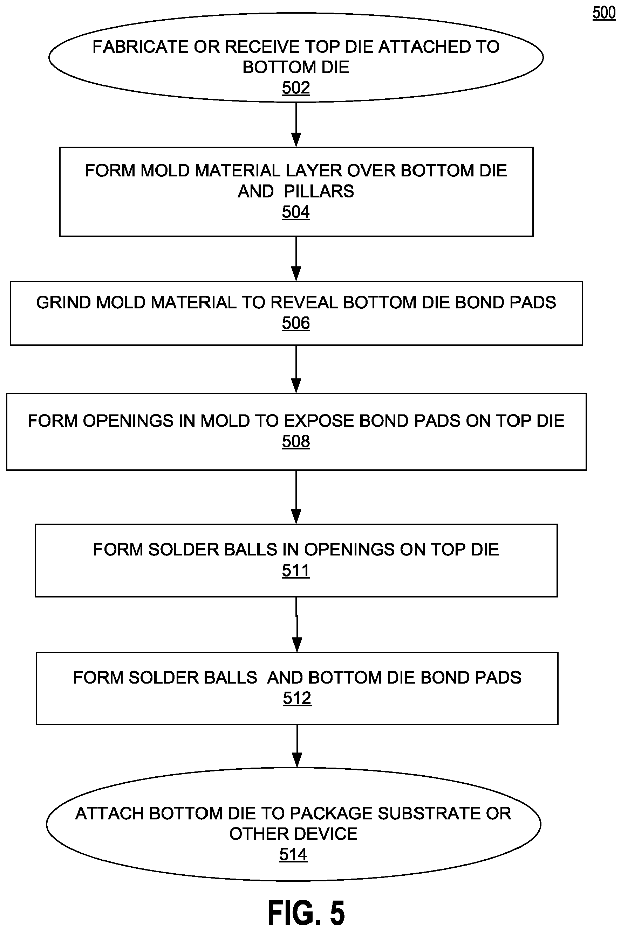

**Fig. 5** illustrates a flow diagram of methods for assembling an IC package having bottom-side dies and interconnect structures encased in mold under a top-side die according to some embodiments. Methods 500 begin at 502, where a top-side IC die attached via hybrid bonding to at least one bottom side IC die is fabricated, or received as a preform that has been fabricated upstream of methods 100. A plurality of top-side IC dies may be fabricated monolithically from a substrate, such as a glass or silicon (e.g., monocrystalline) starting wafer. Similarly, a plurality of bottom side IC die may be fabricated monolithically from a substrate, such as a glass or silicon (e.g., monocrystalline) starting wafer.

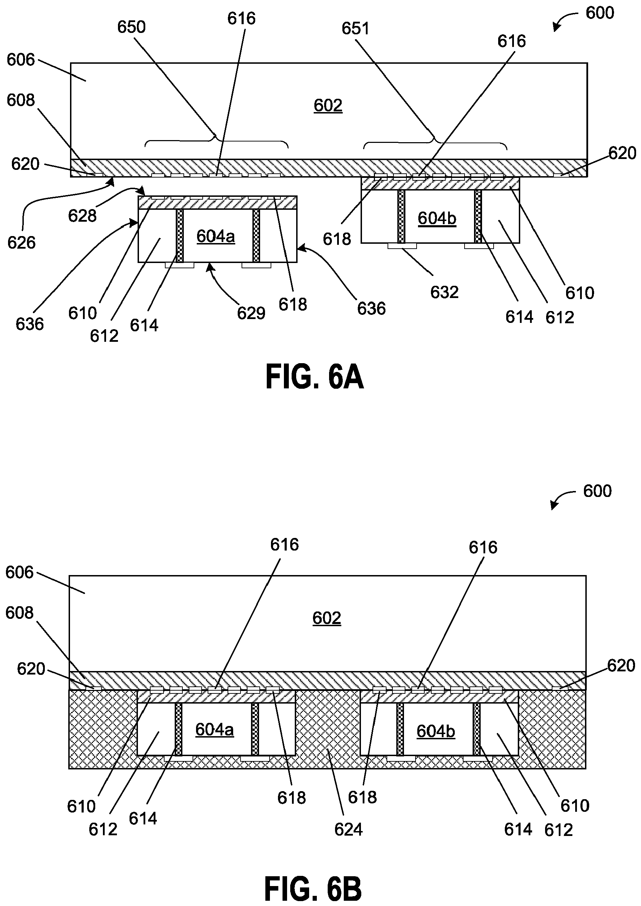

**Fig. 6A** is a cross-sectional illustration of one IC package 600 that may be received as a starting material at 502. Although only one IC package 600 is illustrated, IC package 600 may be one of IC package 600 of a monolithic wafer or reconstituted panel suitable for wafer-level or panel-level assembly.

IC package 600 comprises a top-side IC die 602 and at least one bottom-side IC die 604. In **Fig. 6A****,** bottom-side IC die 604a and bottom-side IC die 604b are shown. In various embodiments, multiple bottom-side IC die 604 may be attached to top-side integrated circuit die 602. While bottom-side IC die 604a is shown as not being attached to top-side die 602 in **Fig. 6A****,** this only so that die surfaces 626, 628 can be easily seen. Contrary to **Fig. 6A****,** and as illustrated in **Figs. 2B -2H****,** bottom-side IC die 604a is attached to top-side die 602. In some embodiments, bottom-side IC dies 604a, 604b are thicker than 30 microns. In some embodiments, bottom-side IC dies 604a, 604b are thicker than 40 microns.

Top-side IC die 602 comprises a device layer 606 and back-end-of-line (BEOL) metallization layer 608 that has been monolithically fabricated over device layer 606. Top-side integrated circuit IC die 602 can comprise one or more device layers 606. Similarly, top-side integrated circuit IC die 602 can comprise one or more metallization layers 608. Top-side IC die 602 includes a first surface 626, which can be a top surface of top-side IC die 602 as shown, or a bottom surface in some embodiments.

During front-end-of-line (FEOL) processing, active and/or passive devices are fabricated in device layer 606 at some device density associated with some device pitch. In some embodiments, the active devices are field effect transistors (FETs) with a device pitch of 80nm, or less. The FETs may be of any architecture (e.g., planar, non-planar, single-gate, multi-gate). In some embodiments, FET terminals have a feature pitch of 40-80nm. Additionally, or in the alternative, device layer 606 may include active devices other than FETs. For example, device layer 606 may include electronic memory structures, such as magnetic tunnel junctions (MTJs), or the like. In addition to active devices, or instead of active devices, device layer 606 may include passive devices (e.g., resistors, capacitors, inductors, etc.).

During BEOL processing, active and passive devices of device layer 606 are interconnected into circuitry with metal structures within one or more metallization layers 608. In some examples where device layer 606 includes both n-type and p-type FETs, the FETs are interconnected by metal structures into a CMOS circuitry. A metallization layer 608 may comprise any number of metal structures separated by inter-layer dielectric (ILD) material.

As illustrated in **Fig. 6A****,** top-side IC die 602 further includes a plurality of first metal features 616 and one or more a second metal features 620 embedded within metallization layer 608 on the first surface 626. Because the plurality of first metal features 616 interface with two or more bottom-side IC die 604, the plurality of first metal features 616 may be referred to, for ease of reference, as having groups or sets of metal features associated with a particular bottom-side IC die 604. Specifically, a first group or set of the plurality of first metal features 616 for interfacing with bottom-side IC die 604a may be referred to herein, and in the claims, as a first hardware interface 650. A second group or set of the plurality of first metal features 616 for interfacing with bottom-side IC die 604b may also be referred to herein, and in the claims, as a first hardware interface 651.

Each bottom-side IC die 604a, 604b comprises a device layer 612 and BEOL metallization layer 610 that has been monolithically fabricated over device layer 612. Bottom-side IC dies 604a, 604b can comprise one or more device layers 612. Similarly, bottom-side IC dies 604a, 604b can comprise one or more metallization layers 610.

Each bottom-side IC die 604a, 604b includes a first surface 628, which can be a top surface of bottom-side IC dies 604a, 604b as shown, or a bottom surface in some embodiments. Each of bottom-side IC die 604a and 604b includes a second surface 630 opposite the first surface 628. In addition, each of bottom-side IC die 604a and 604b includes a plurality of sidewalls or sidewall structures 636, e.g., four. Sidewalls 636 extend from first surface 628 to second surface 629 of bottom-side IC dies 604a, 604b.

Any of the active and passive devices described above as being fabricated in device layer 606 for top-side IC die 602 may be similarly fabricated in device layer 612 in each bottom-side IC die 604a, 604b. Like the metal structures within one or more metallization layers of 608 of top-side IC die 602, metal structures within one or more metallization layers 610 in each bottom-side IC die 604a, 604b interconnect active devices of device layer 612 into circuitry. In some embodiments, the circuitry in top-side IC die 602 and bottom-side IC die 604 may be the same. However, in other embodiments, the architectures and/or functions of circuitry in top-side IC die 602 may be different from the architectures and/or functions of circuitry in bottom-side IC dies 604a, 604b.

As illustrated in **Fig. 6A****,** bottom-side IC dies 604a, 604b further include a plurality of third metal features 618 on first surface 628. The plurality of third metal features 618 are embedded within metallization layer 610 on first surface 628. The plurality of third metal features 618 are embedded within a dielectric material in metallization layer 610. The plurality of third metal features 618 may be referred to herein as a second hardware interface. In addition, bottom-side IC dies 604a, 604b include at least one bond pad 632 on a second surface 629 opposite the first surface 628.

In embodiments, bottom-side IC dies 604a, 604b are attached to top-side IC die 602 via direct or hybrid bonding, in which bonds are formed between both metallization features of bottom-side IC dies 604a, 604b and top-side IC die 602 (e.g., via metal interdiffusion) and between dielectric materials of bottom-side IC dies 604a, 604b and top-side IC die 602.

With reference to bottom-side IC die 604b in **Fig. 6A** - **6E****,** one or more of the plurality of third metal features 618 of bottom-side IC die 604b are in direct contact with one or more of the plurality of first metal features 616 of top-side IC die 602. In embodiments, metal features 618 (conductive contacts) of the second hardware interface at surface 628 of second IC die 604b are in direct contact with metal features 616 (conductive contacts) of one of first hardware interface 650 of top-side IC die 602.

With reference to bottom-side IC die 604a, as illustrated in in Figs. 6B - 6E, one or more of the plurality of third metal features 618 of die 604a are in direct contact with one or more the plurality of first metal features 616 of die 602. These one or more of the plurality of first metal features 616 of die 602 contacting third metal features 618 of die 604a may alternatively be referred to as a second group or a second set of the plurality of first metal features 616. In embodiments, metal features 618 (conductive contacts) of a fourth hardware interface at surface 628 of second IC die 604a are in direct contact with metal features 616 (conductive contacts) of one of first hardware interface 650 of top-side IC die 602.

Returning to **Fig. 5****,** methods 500 continue at 504 where a mold material layer is formed. **Fig. 6B** is a cross-sectional illustration of IC package 600 showing at least one bottom-side IC die, e.g., bottom-side IC dies 604a, 604b, at least partially encased in mold material layer 624 over surface 626. Mold material layer 624 may also be referred to in this description and in the claims as "mold compound." The mold material layer or mold compound 624 may be any suitable an organic plastic material, such as an epoxy material. Mold material 624 may have a relatively low electrical conductivity, with mold material 624 advantageously being a dielectric. Mold material 624 may be any alternative material known to be suitable for IC chip packaging applications. In some exemplary embodiments, mold material 624 comprises a cured (e.g., thermoset) resin or polymer comprising epoxy and/or silicone. Mold material 624 may also comprise a variety of fillers. In some embodiments, mold material 624 has a relatively low bulk thermal conductivity (e.g., less than 5 W/mK), and may, for example, have a bulk thermal conductivity in the range of 1-4 W/mK. The processing and techniques for encasing integrated circuit device in a mold material layer are well known in the art and for purposes of clarity and conciseness are not discussed herein. Any suitable methods known in the art may be employed.

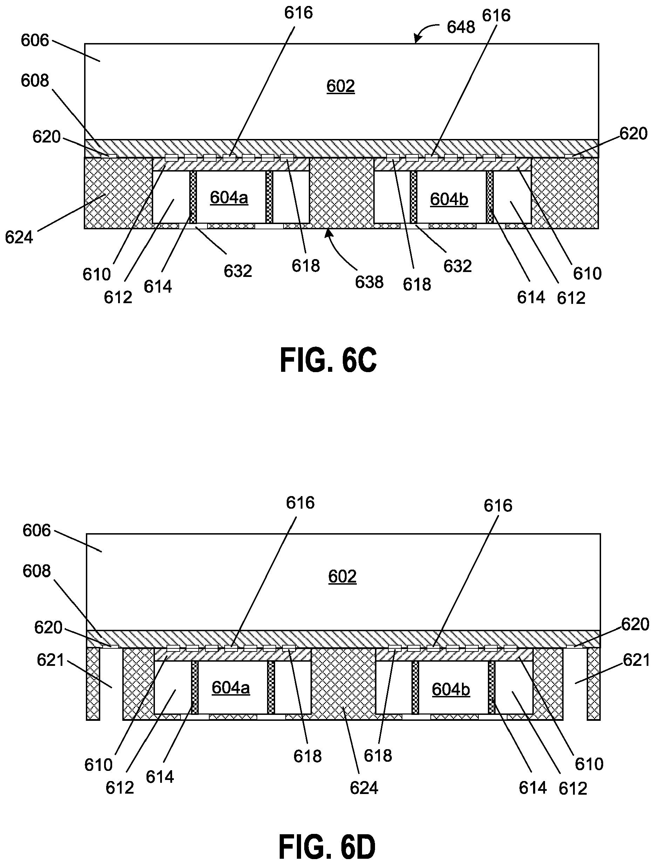

Returning to **Fig. 5****,** methods 500 continue at 506 where mold material 624 is planarized to expose bond pads 632 of bottom-side IC dies 604a, 604b. For example, a grind and/or polish process may partially remove and/or planarize the mold material 624 to expose to reveal bottom-side die pads 632. **Fig. 6C** is a cross-sectional illustration of IC package 600 after mold material 624 has been planarized. As can be seen in the figure, bottom-side die pads 632 are exposed. It should be appreciated that mold material layer 624 defines a side 638 of IC package 600. Top-side IC die 602 has a first surface 626 and a second surface 648 opposite first surface 626. Second surface 648 defines a side of IC package 600 which is opposite side 638 defined by the mold material layer 624.

In various embodiments, mold material layer 624 is a rigid body comprising a mold compound. The rigid body adjoins sidewall structure of 636 of bottom-side IC dies 604a, 604b. In addition, rigid body adjoins first surface 626 of top-side die 602.

Returning to **Fig. 5****,** methods 500 continue at 508 in **Fig. 5****,** where at least one opening 621 in mold material 624 is formed. **Fig. 6D** is a cross-sectional illustration of IC package 600 showing openings 621 formed in mold material 624. The openings 621 may be formed using a drilling process. Openings 621 can be drilled using a laser drill or a mechanical drill, as is known in the art. As illustrated in **Fig. 6D****,** opening 621 has substantially vertical and parallel sidewalls. While opening 621 may have substantially vertical and parallel sidewalls in some embodiments, in other embodiments, the sidewalls of opening 621 are not parallel and the opening resembles a cone. When opening 621 is formed with a laser drill, the energy of the laser beam is at a maximum at the beam center and decays toward the periphery of the beam, which results in more material removal at the center of the opening as compared with the outer edge of the opening. With laser drilling, the radius of the hole decreases with increasing hole depth. Laser drilling produces an opening that is more cone-shaped than cylindrical. Opening 621 is formed over second metal features 620, and the metal in the features may function as a laser stop, so that the laser beam does not penetrate into lower substrate layers.

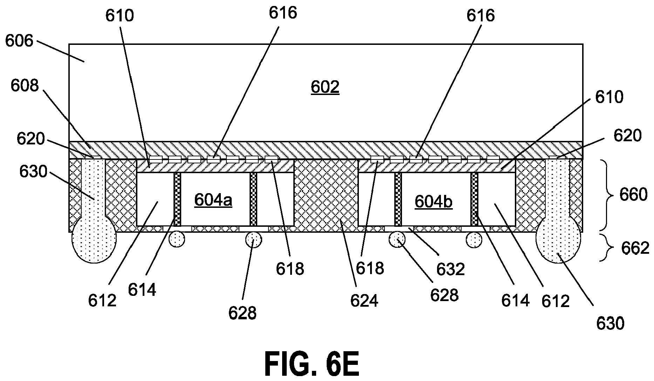

Returning to **Fig. 5****,** methods 500 continue at 511 in **Fig. 5****,** where interconnect structures 630 are formed in openings 621 and solder balls 628 are formed on bond pads 632. **Fig. 6E** is a cross-sectional illustration of IC package 600 showing interconnect structures 630 formed in openings 621 and solder balls 628 formed on bond pads 632. In embodiments, interconnect structures 630 are solder features, each comprising a cavity-filling portion 660 and a bump portion 662. The cavity-filling portion 660 has a shape that conforms to the profile of opening 621. Accordingly, cavity filling portion 660 may be substantially cylindrical shaped or shaped substantially cone-like shaped. The bump portion 662 may have a spherical shape. In embodiments, bump portion 662 interconnect structure 630 may be a first size and solder balls 628 may be a second size. For example, bump portion 662 may have a height of about 100 microns to facilitate electrical connection to at package substrate, whereas solder balls 628 may have a height of about 33 microns for electrically connecting with an IC die. The solder used in interconnect structures 630 and solder balls 628 may be of any solder composition known to be suitable for electrically connecting IC dies. In some embodiments, the solder may comprise a metal, such as a, Sn-Ag--Cu (SAC) alloy. The interconnect structures 630 each adjoin and extend through the mold compound of the rigid body. Sides of cavity-filling portion 660 adjoin the mold compound of the rigid body. Referring to **Figs. 6A****,** **6C****, and** **6E****,** a distance between the side 626 of the IC die 602 and side 638 of mold material layer 624 is greater than 90 microns in some embodiments. End surfaces of interconnect structures 630 at an end opposite the side 626 of the IC die 602 are in a plane with side 638 of mold material layer 624. Accordingly, interconnect structures 630 may have a height greater than 90 microns in some embodiments.

Returning to **Fig. 5****,** methods 500 may continue at 514 where the bottom-side die is attached to a package substrate or other device. Bottom-side IC dies 604a, 604b may be connected to a package substrate or other device via the solder balls 628 on die pads 632. Top-side IC die 602 may be connected to a package substrate or other device via the solder interconnect structures 630.

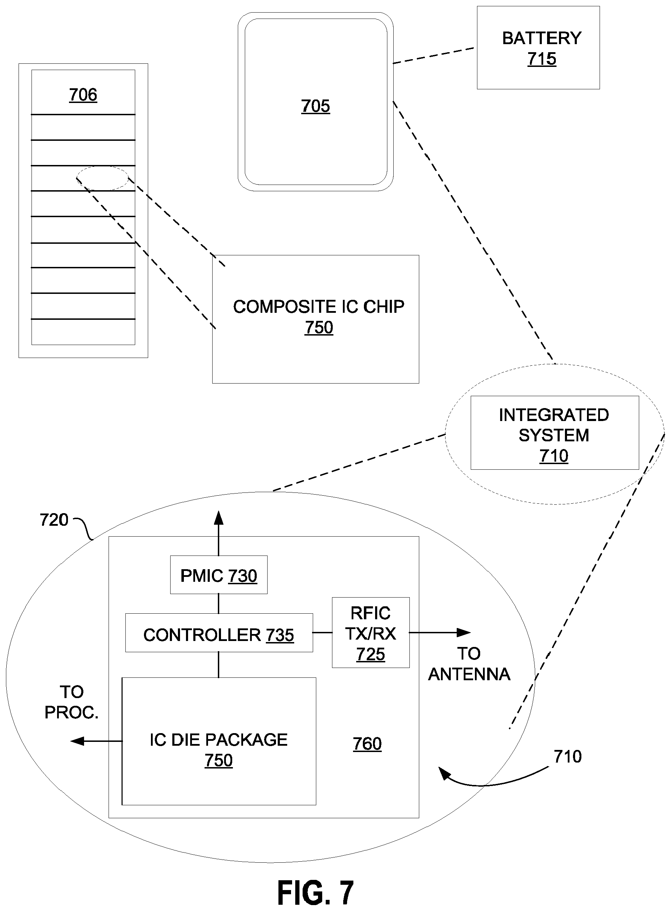

**FIG. 7** illustrates a mobile computing platform 705 and a data server machine 706 employing an IC die package 750 including a top-side IC die stacked on and directly bonded to a bottom-side IC die, an interconnect structure adjacent to the bottom-side IC die, and a rigid body comprising a mold compound encasing the bottom-side IC die, an interconnect structure, for example as described elsewhere herein. Server machine 706 may be any commercial server, for example including any number of high-performance computing platforms disposed within a rack and networked together for electronic data processing, which in the exemplary embodiment includes an IC die package 750 including a top-side IC die stacked on and directly bonded to a bottom-side IC die, a through-mold interconnect structure adjacent to the bottom-side IC die, and a rigid body comprising a mold compound encasing the bottom-side IC die and an interconnect structure, for example as described elsewhere herein. The mobile computing platform 705 may be any portable device configured for each of electronic data display, electronic data processing, wireless electronic data transmission, or the like. For example, the mobile computing platform 705 may be any of a tablet, a smart phone, laptop computer, etc., and may include a display screen (e.g., a capacitive, inductive, resistive, or optical touchscreen), an integrated system 710, and a battery 715.

Whether disposed within the integrated system 710 illustrated in the expanded view 720, or as a stand-alone package within the server machine 706, IC die package 750 may include a top-side IC die stacked on and directly bonded to a bottom-side IC die, a through-mold interconnect structure adjacent to the bottom-side IC die, and a rigid body comprising a mold compound encasing the bottom-side IC die and an interconnect structure. IC die package 750 may be further coupled to a host substrate 760, along with, one or more of a host controller 735, PMIC 730, an RF (wireless) integrated circuit (RFIC) 725 including a wideband RF (wireless) transmitter and/or receiver may be further coupled to host component 905. PMIC 730 may perform battery power regulation, DC-to-DC conversion, etc., and so has an input coupled to battery 715 and with an output providing a current supply to other functional modules. As further illustrated, in the exemplary embodiment, RFIC 725 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, and beyond.

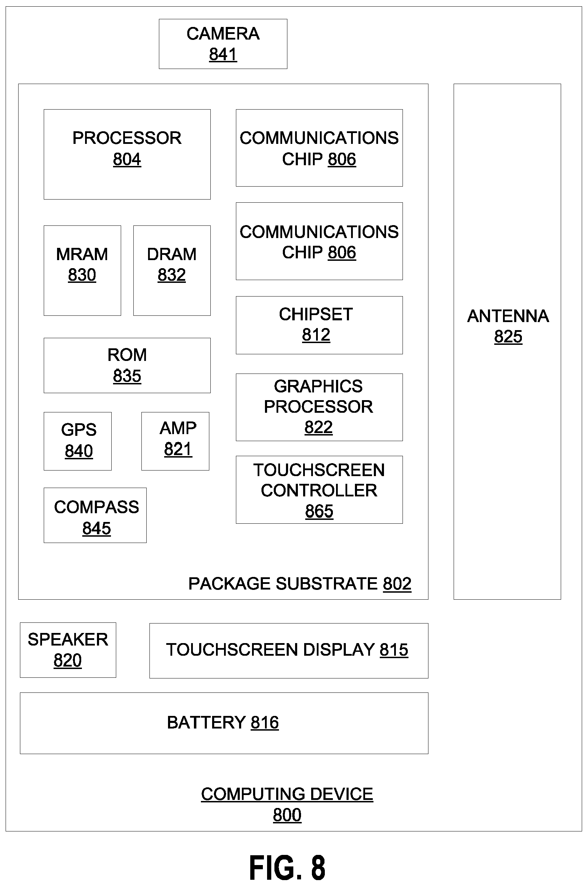

**Fig. 8** is a functional block diagram of an electronic computing device 800, in accordance with an embodiment of the present invention. Computing device 800 may be found inside either mobile computing platform 705 or server machine 06, for example. Device 800 further includes a package substrate 802 hosting a number of components, such as, but not limited to, a processor 804 (e.g., an applications processor). Processor 804 may be physically and/or electrically coupled to package substrate 802. In some examples, processor 804 is within includes an IC die package including a top-side IC die stacked on and directly bonded to a bottom-side IC die, a through-mold interconnect structure adjacent to the bottom-side IC die, and a rigid body comprising a mold compound encasing the bottom-side IC die and an interconnect structure, for example as described elsewhere herein. Processor 804 may be implemented with circuitry in any or all of the IC die of the IC die package. In general, the term "processor" or "microprocessor" may refer to any device or portion of a device that processes electronic data from registers and/or memory to transform that electronic data into other electronic data that may be further stored in registers and/or memory.

In various examples, one or more communication chips 806 may also be physically and/or electrically coupled to the package substrate 802. In further implementations, communication chips 806 may be part of processor 804. Depending on its applications, computing device 800 may include other components that may or may not be physically and electrically coupled to package substrate 802. These other components include, but are not limited to, volatile memory (e.g., DRAM 832), non-volatile memory (e.g., ROM 835), flash memory (e.g., NAND or NOR), magnetic memory (MRAM 830), a graphics processor 822, a digital signal processor, a crypto processor, a chipset 812, an antenna 825, touchscreen display 815, touchscreen controller 865, battery 816, audio codec, video codec, power amplifier 821, global positioning system (GPS) device 840, compass 845, accelerometer, gyroscope, speaker 820, camera 841, and mass storage device (such as hard disk drive, solid-state drive (SSD), compact disk (CD), digital versatile disk (DVD), and so forth), or the like. In some exemplary embodiments, at least two of the functional blocks noted above are within a composite IC die package structure including a IC die bonded to two sides of an interposer, for example as described elsewhere herein. For example, processor 804 be implemented with circuitry in an IC die on a first side of the interposer, and an electronic memory (e.g., MRAM 830 or DRAM 832) may be implemented with circuitry in an IC die on a second side of the interposer.

Communication chips 1106 may enable wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1106 may implement any of a number of wireless standards or protocols. As discussed, computing device 1100 may include a plurality of communication chips 1106. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example, the above embodiments may include specific combinations of features as further provided below.

The following examples pertain to further embodiments. Specifics in the examples may be used anywhere in one or more embodiments. All optional features of the apparatus described herein may also be implemented with respect to a method or process. The examples can be combined in any combinations. For example, example 4 can be combined with example 2.

Example 1: An integrated circuit (IC) package comprising: a first IC die comprising a first hardware interface at a first side of the first IC die, and one or more first conductive contacts at the first side; a second IC die coupled to the first IC die, the second IC die comprising a second hardware interface at a second side of the second IC die, wherein second conductive contacts of the first hardware interface are each in direct contact with a respective one of third conductive contacts of the second hardware interface, and a sidewall structure of the second IC die extends to the second side and to a third side of the second IC die; a rigid body comprising a mold compound, and adjoining the sidewall structure and the first side, wherein a side of the IC package is formed at least in part by the rigid body; and a third hardware interface comprising: one or more interconnect structures, each coupled to a respective one of the one or more first conductive contacts and each comprising a fourth conductive contact, and fifth conductive contacts at the third side, wherein the one or more interconnect structures each adjoin and extend through the rigid body to electrically couple the third hardware interface to the first IC die.

Example 2: The IC package of example 1, wherein the one or more interconnect structures are conductive pillars comprised of copper.

Example 3: The IC package of example 1, wherein the one or more interconnect structures are solder features, each comprising a cavity filling portion and a bump portion.

Example 4: The IC package of example 1, wherein the mold compound comprises an organic material.

Example 5. The IC package of example 1, wherein the second IC die further comprises a through-silicon via connecting one of the fifth conductive contacts with a metal interconnect layer of the second IC die.

Example 6: The IC package of example 1, wherein a thickness of the second IC die is greater than 40 microns.

Example 7: The IC package of example 1, wherein a distance between the first side of the first IC die and the fourth conductive contacts of the one or more interconnect structure is greater than 90 microns.

Example 8: An integrated circuit (IC) package comprising: a first IC die comprising a first hardware interface at a first side of the first IC die, and one or more first conductive contacts at the first side; a second IC die coupled to the first IC die, the second IC die comprising a second hardware interface at a second side of the second IC die, wherein second conductive contacts of the first hardware interface are each in direct contact with a respective one of third conductive contacts of the second hardware interface; and a third hardware interface comprising: one or more interconnect structures, each coupled to a respective one of the one or more first conductive contacts and each comprising a fourth conductive contact, and fifth conductive contacts at a third side of the second IC die, wherein the one or more interconnect structures are each to electrically couple the third hardware interface to the first IC die.

Example 9: The IC package of example 8, wherein the second IC die further comprises a sidewall structure that extends to the second side and to the third side of the second IC die, and the IC package further comprises: a rigid body comprising a mold compound, the rigid body adjoining the sidewall structure of the second die and the first side, wherein a side of the IC package is formed at least in part by the rigid body, and the one or more interconnect structures each adjoin and extend through the rigid body.

Example 10: The IC package of example 9, wherein the mold compound comprises an organic material.

Example 11: The IC package of example 8, wherein the one or more interconnect structures are conductive pillars comprised of copper.

Example 12: The IC package of example 8, wherein the second IC die further comprises a through-silicon via connecting one of the fifth conductive contacts with a metal interconnect layer of the second IC die.

Example 13: The IC package of example 8, wherein a thickness of the second IC die is greater than 40 microns.

Example 14: The IC package of example 8, wherein a distance between the first side of the first IC die and the fourth conductive contacts of the one or more interconnect structure is greater than 90 microns.

Example 15: A system comprising: a power supply; an integrated circuit (IC) package coupled to the power supply, comprising: a first IC die comprising a first hardware interface and one or more first conductive contacts a first side of the first IC die; a second IC die comprising a second hardware interface at a second side of the second IC die, and a sidewall structure extending to the second side and to a third side of the second IC die, wherein the first hardware interface and the second hardware interface are in direct contact, a rigid body comprising a mold compound, and adjoining the sidewall structure and the first side, wherein a side of the IC package is formed at least in part by the rigid body; and a third hardware interface comprising: one or more interconnect structures, each coupled to a respective one of the one or more first conductive contacts and each comprising a fourth conductive contact, and fifth conductive contacts at the third side, wherein the one or more interconnect structures each adjoin and extend through the rigid body to electrically couple the third hardware interface to the first IC die.

Example 16: The system of example 16, wherein: the first IC die comprises memory circuitry to store data; and the second IC die comprises logic circuity to execute instructions on the data.

Example 17: The system of example 15, wherein: the first hardware interface comprises second conductive contacts; and the second hardware interface comprises third conductive contacts, wherein the second conductive contacts of the first hardware interface are each in direct contact with a respective one of the third conductive contacts of the second hardware interface.

Example 18: The system of example 15, wherein the mold compound comprises an organic material.

Example 19: The system of example 15, wherein the one or more interconnect structures are comprised of copper or solder.

Example 20: The system of example 15, wherein a thickness of the second IC die is greater than 40 microns.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed. The scope of the invention should therefore be determined with reference to the appended claims, along with the full scope of equivalents to which such claims are entitled.

## Claims

1. An integrated circuit (IC) package comprising:
a first IC die comprising one or more first conductive contacts and one or more second conductive contacts at a first side of the first IC die;
a second IC die coupled to the first IC die, the second IC die comprising third conductive contacts in direct contact with respective ones of the first conductive contacts;
a body comprising a mold compound, the body contacting a sidewall of the second IC die and the first side of the first IC die;
one or more interconnect structures extending through the body, each of the interconnect structures coupled to a respective one of the second conductive contacts; and
fourth conductive contacts at a second side of the second IC die, opposite the first side of the first IC die.

2. The IC package of claim 1, wherein the one or more interconnect structures are conductive pillars comprised of copper.

3. The IC package of claim 1, wherein the one or more interconnect structures are solder features, each comprising a cavity filling portion and a bump portion.

4. The IC package of claim 3, further comprising solder features on the fourth conductive contacts, wherein the bump portion comprises a first size, and the solder features on the fourth conductive contacts comprise a second size, the second size being smaller than the first size.

5. The IC package of any of claims 1 through 4, wherein the mold compound comprises an organic material.

6. The IC package of any of claims 1 through 5, further comprising a package substrate, wherein:
the one or more interconnect structures further comprise fifth conductive contacts at first end surfaces opposite second end surfaces coupled to respective ones of the second conductive contacts; and
the fifth conductive contacts are coupled with the package substrate.

7. The IC package of any of claims 1 through 6, wherein a thickness of the second IC die is greater than 40 microns.

8. The IC package of any of claims 1 through 7, wherein the one or more interconnect structures further comprise fifth conductive contacts at first end surfaces opposite second end surfaces coupled to respective ones of the second conductive contacts; and
a distance between the first side of the first IC die and the fifth conductive contacts of the one or more interconnect structure is greater than 90 microns.

9. The IC package of any of claims 1 through 8, wherein:
the one or more interconnect structures further comprise fifth conductive contacts at first end surfaces opposite second end surfaces coupled to respective ones of the second conductive contacts; and
the fourth conductive contacts and the fifth conductive contacts are a same distance from the first side of the first IC die.

10. A method comprising:
receiving a first IC die and a second IC die coupled to the first IC die,
wherein the first IC die comprises one or more first conductive contacts and one or more second conductive contacts at a first side of the first IC die, and
the second IC die comprises third conductive contacts in direct contact with respective ones of the first conductive contacts;
forming one or more interconnect structures, wherein each of the interconnect structures are coupled to a respective one of the second conductive contacts.

11. The method of claim 10, further comprising:
applying photoresist over the first side of the first IC die and over the second IC die; and
forming at least one opening in the photoresist, wherein the forming one or more interconnect structures comprises:
forming the one or more interconnect structures in the at least one opening in the photoresist, wherein the one or more interconnect structures are conductive pillars comprised of copper.

12. The method of claim 11, further comprising:
removing the photoresist; and
forming a body comprising a mold compound, the body contacting a sidewall of the second IC die and the first side of the first IC die, wherein the one or more interconnect structures extend through the body.

13. The method of claim 11, further comprising removing the photoresist.

14. The method of any of claims 10-13, further comprising:
forming a body comprising a mold compound, the body contacting a sidewall of the second IC die and the first side of the first IC die; and
forming at least one opening in the body, wherein the forming one or more interconnect structures comprises:
forming the one or more interconnect structures in the at least one opening in the body wherein the one or more interconnect structures are solder features, each comprising a cavity filling portion and a bump portion.

15. The method of any of claims 10 through 14, further comprising:
forming solder balls on the one or more interconnect structures and bond pads of the second IC die; and
attaching the second IC die to a package substrate.
